(19) Europäisches Patentamt
European Patent Office
Office européen des brevets

(11) Veröffentlichungsnummer: **0 042 567**
**A2**

(12) # EUROPÄISCHE PATENTANMELDUNG

(21) Anmeldenummer: 81104602.8

(22) Anmeldetag: 15.06.81

(51) Int. Cl.³: G 03 C 1/68
C 07 F 9/40, C 08 F 2/50
C 08 L 67/06, C 08 K 5/53

(30) Priorität: 24.06.80 DE 3023486

(43) Veröffentlichungstag der Anmeldung: 30.12.81 Patentblatt 81/52

(84) Benannte Vertragsstaaten: BE DE FR IT

(71) Anmelder: BAYER AG
Zentralbereich Patente, Marken und Lizenzen
D-5090 Leverkusen 1, Bayerwerk(DE)

(72) Erfinder: Heine, Hans-Georg, Dr.
Am Heckerhof 14
D-4150 Krefeld 1(DE)

(72) Erfinder: Rosenkranz, Hans Jürgen, Dr.
Heinrich-Kauert-Weg 9
D-4150 Krefeld(DE)

(72) Erfinder: Rudolph, Hans, Dr.
Haydnstrasse 9
D-4150 Krefeld 1(DE)

(54) **Photopolymerisierbare Mischungen mit Aroylphosphonsäureestern als Photoinitiatoren.**

(57) Mischungen enthaltend, bezogen auf Summe aus Monomer und Photoinitiator,
a) 85 bis 99,9 Gew.-% mindestens eines üblichen Monomeren mit mindestens einer ethylenisch ungesättigten, photopolymerisierbaren Bindung und b) 0,1 bis 15 Gew.-% mindestens eines Aroylphosphonsäurediesters der Formel I

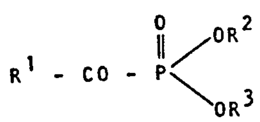

(1)

als Photoinitiator, worin $R^1$ einen Phenyl-, Naphthyl-, Pyridyl- oder Furylrest oder einen der vorstehenden Reste, die durch Halogen (F, C1, Br) $C_1$-$C_4$ Alkyl-, $C_1$-$C_4$ Alkoxi-, Alkoxicarbonylmit 1 bis 4 C-Atomen in der Alkoxigruppe, Phenyl- oder Nitro-(-$NO_2$)gruppen substituiert sind, bedeutet, und $R^2$ und $R^3$ gleich oder verschieden einen $C_1$-$C_4$ Alkyl-, $C_2$-$C_4$ Alkenyl- oder Benzyl-rest oder einen der vorstehenden, durch Halogen (F, Cl, Br), Trihalogenmethyl- oder $C_1$-$C_4$ Alkoxigruppen substituierten Rest oder $R^2$ und $R^3$ zusammen eine Alkylengruppe (-$CH_2$-)x darstellen, wobei x eine Zahl von 2 bis 4 ist.

EP 0 042 567 A2

BAYER AKTIENGESELLSCHAFT 5090 Leverkusen, Bayerwerk

Zentralbereich
Patente, Marken und Lizenzen Fr/m



# Photopolymerisierbare Mischungen mit Aroylphosphonsäureestern als Photoinitiatoren

Die Erfindung betrifft photopolymerisierbare Mischungen aus Aroylphosphonsäureestern als Photoinitiatoren und mindestens einem Monomeren mit mindestens einer ethylenisch ungesättigten, photopolymerisierbaren Doppelbindung.

Initiatoren für die UV-Licht-induzierte Polymerisation von Vinyl- und Vinylidenverbindungen oder deren Abmischungen mit ethylenisch ungesättigten Polymeren sind bekannt: aromatische Disulfide (DE-PS 1 233 594), Azoverbindungen (Chem. Rev. 68, 125 (1968), Diarylketone (US-PS 2 367 661, 2 367 670), α-Halogenketone (C.M. McClosky und J. Bond, Ind. Eng. Chem. 47, 2125 (1955); US-PS 2 548 685, 2 641 576) und ß-Ketosulfide (DE-PS 1 769 168). In der Reihe der Carbonylverbindungen kommt den Acyloinen, insbesondere dem Benzoin und seinen Derivaten (US-PS 2 367 661), größte technische Bedeutung zu. Dementsprechend gehören Benzoinderivate zu den bestuntersuchten Photoinitiatoren (vgl. H.-G. Heine, H.- J.Rosenkranz und H. Rudolph, Angew. Chem. 84, 1032, (1972)). Obwohl sie zu den technisch interessantesten Photoinitiatoren zählen, besteht auch weiterhin ein Bedürfnis nach neuen Photoinitiatoren.

Die Eignung von Photoinitiaren hängt in hohem Maße von der Konstitution des verwendeten ungesättigten Substrats ab:

So erweisen sich beispielsweise Benzoinether sekundärer und tertiärer Alkohole bei der UV-Härtung ungesättigter Polyesterharze als hochreaktive Photoinitiatoren, während sie sich als Starter für die Polymerisation von (Meth-)Acrylsäure oder den entsprechenden polymerisationsfähigen Derivaten weniger eignen: Sie zeigen dabei zu niedrige Reaktivität und verleihen den zu polymerisierenden (Meth-)Acrylverbindungen keine zufriedenstellende Lagerstabilität.

Zwar steht im Benzildimethylketal (DE-OS 2 337 813) eine reaktive Verbindung zur Verfügung, die die Polymerisation von (Meth-) Acrylverbindungen außerordentlich rasch initiiert; sie ruft allerdings eine unerwünschte Vergilbung der gehärteten Produkte hervor, so daß ihre Verwendbarkeit stark eingeschränkt ist. Benzophenon/Triethanolamin andererseits ergibt bei ebenfalls hervorragender Reaktivität farblose Überzüge. Doch wird Benzophenon bei der Polymerisation nicht so in den Polymerisatfilm eingebaut, daß nicht sein relativ starker Geruch bei praktisch allen Anwendungen stören würde.

Überraschenderweise wurde nun gefunden, daß Aroylphosphonsäurediester als Photoinitiatoren für die Polymerisation radikalisch polymerisierbarer ethylenisch ungesättigter organischer Verbindungen oder deren Gemische, insbesondere von (Meth-) Acrylsäure-Derivaten außerordentlich gut geeignet sind, da sie eine rasche Polymerisationsinitiierung bewirken, in fast allen Fällen eine vergilbungsfreie Aushärtung ermöglichen, und den zu polymerisierbaren Verbindungen eine ausgezeichnete Dunkellagerstabilität verleihen. Darüberhinaus sind diese Initiatoren geruchlos und leicht zugänglich.

Gegenstand der Erfindung sind Mischungen, enthaltend, bezogen auf Summe aus Monomer und Photoinitiator,

a) 85 bis 99.9 Gew.-%, vorzugsweise 92 bis 99.5 Gew.-%, mindestens eines üblichen Monomeren mit mindestens einer ethylenisch ungesättigten, photopolymerisierbaren Doppelbindung und

b) 0.1 bis 15 Gew.-%, vorzugsweise 0.5 bis 8 Gew.-%, mindestens eines Photoinitiators,

dadurch gekennzeichnet, daß der Photoinitiator ein Aroylphosphonsäurediester der Formel I

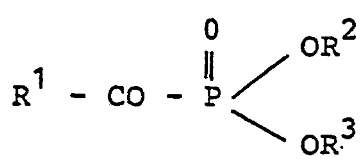

(I)

ist,
worin

$R^1$ einen Phenyl-, Naphthyl-, Pyridyl- oder Furylrest oder einen der vorstehenden Reste, die durch Halogen (F, Cl, Br) $C_1$-$C_4$ Alkyl-, $C_1$-$C_4$ Alkoxi-,

Alkoxicarbonyl- mit 1 bis 4 C-Atomen in der Alkoxigruppe, Phenyl- oder Nitro-($-NO_2$)gruppen substituiert sind, bedeutet und

$R^2$ und $R^3$ gleich oder verschieden einen $C_1$-$C_4$ Alkyl-, $C_2$-$C_4$ Alkenyl- oder Benzylrest oder einen der vorstehenden, durch Halogen (F, Cl, Br), Trihalogenmethyl- oder $C_1$-$C_4$ Alkoxigruppen substituierten Rest oder $R^2$ und $R^3$ zusammen eine Alkylengruppe $(-CH_2-)_x$ darstellen, wobei x eine Zahl von 2 bis 4 ist.

Vorzugsweise bedeuten in Formel I $R^1$ Phenyl oder durch F oder Cl, $C_1$-$C_4$-Alkyl, $C_1$-$C_4$ Alkoxi, Alkoxicarbonyl mit 1-4 C-Atomen in der Alkoxigruppe oder durch $NO_2$ substituiertes Phenyl und $R^2$ und $R^3$ gleich oder verschieden Methyl oder Ethyl.

Als Beispiele für Verbindungen der Formel I seien die folgenden namentlich aufgeführt:

Benzoylphosphonsäure-dimethylester
" -diethylester
" -di-n-butylester
" -methyl-ethylester
" -di-(2-chlorethyl)-ester
" -diallylester
" -di-isopropylester
" -ethylenester
2-Chlorbenzoylphosphonsäure-dimethylester
" -diethylester
4-Chlorbenzoylphosphonsäure-dimethylester

4-Methylbenzoylphosphonsäure-dimethylester
" -di-n-butylester
3-Methoxybenzoylphosphonsäure-dimethylester
4-Methoxybenzoylphosphonsäure-dimethylester
4-tert.-Butylbenzoylphosphonsäure-dimethylester
2-Methylbenzoylphosphonsäure-dimethylester
3-Methylbenzoylphosphonsäure-diethylester
2-Fluorbenzoylphosphonsäure-dimethylester
4-Phenylbenzoylphosphonsäure-dimethylester
2.4- oder 2.6-Dichlorbenzoylphosphonsäure-dimethylester
2.4.6-Trimethylbenzoylphosphonsäure-dimethylester
2-Trifluormethylbenzoylphosphonsäure-dimethylester
4-Methoxycarbonylbenzoylphosphonsäure-dimethylester
1-Naphthoylphosphonsäure-dimethylester
4-Methoxybenzoylphosphonsäure-di-n-butylester
4-Nitrobenzoylphosphonsäure-dimethylester
2.6-Dimethoxybenzoylphosphonsäuredimethylester

Die aufgeführten, nur zu einem Teil bekannten Aroylphosphonsäureester sind schwach gelbgefärbte Verbindungen. Sie sind für eine Verwendung als Photoinitiatoren im UV-Bereich von 250-500 nm, insbesondere 360 - 450 nm hervorragend geeignet.

In den zum Polymerisationsstart üblichen Mengen von 0.1-15 Gew.-%, bezogen auf ungesättigte Verbindungen, führen sie zu keinerlei Vergilbung der Überzüge. Auch dann nicht, wenn der Film über eine längere Zeit einer starken Lichtquelle ausgesetzt wird.

Die Herstellung der Aroylphosphonsäureester erfolgt nach bekannten Methoden [ Houben-Weyl: Methoden der

Org. Chemie, Bd. 12/1, G. Thieme-Verlag, S. 453, 1963; J.Am.Chem.Soc. 86, 3862 (1964); J.Chem.Soc. 2272 (1959) ] durch Umsetzen der entsprechenden Säurehalogenide mit Alkylphosphiten unter Abspaltung von Alkylhalogeniden und Reinigung mittels fraktionierender Destillation unter vermindertem Druck.

Unter üblichen Monomeren mit mindestens einer ethylenisch ungesättigten, photopolymerisierbaren Doppelbindung werden beispielsweise verstanden:

A. 1) Ester der Acryl- oder Methacrylsäure mit aliphatischen $C_1$-$C_8$, cycloaliphatischen $C_5$-$C_6$, araliphatischen $C_7$-$C_8$ Monoalkoholen, beispielsweise Methylacrylat, Ethylacrylat, n-Propylacrylat, n-Butylacrylat, Methylhexylacrylat, 2-Ethylhexylacrylat und die entsprechenden Methacrylsäureester; Cyclopentylacrylat, Cyclohexylacrylat oder die entsprechenden Methacrylsäureester; Benzylacrylat, ß-Phenylethylacrylat und entsprechende Methacrylsäureester; ferner (Meth) Acrylsäurevinylester; (Meth) Acrylsäureallylester;

2) (Meth) Acrylsäure, (Meth) Acrylamid, (Meth) Acrylnitril;

3) N-Methylolacrylamid oder N-Methylolmethacrylamid sowie entsprechende N-Methylolalkylether mit 1-4 C-Atomen in der Alkylethergruppe bzw. entsprechende N-Methylolallylether, insbesondere N-Methoxymethyl(meth)acrylamid, N-Butoxymethyl(meth)acrylamid und N-Allyloxymethyl(meth)acrylamid;

4) Hydroxialkylester der Acryl- oder Methacrylsäure mit 2-4 C-Atomen in der Alkoholkomponente, wie 2-Hydroxiethylacrylat, 2-Hydroxipropylacrylat, 3-Hydroxipropylacrylat, 2-Hydroxibutylacrylat, 4-Hydroxibutylacrylat oder entsprechende Methacrylsäureester;

5) Di- und Monoester aus Fumar- oder Maleinsäure und aliphatischen $C_1$-$C_8$, cycloaliphatischen $C_5$-$C_6$ oder araliphatischen $C_7$-$C_8$ Monoalkoholen, Vinyl- und/oder Allylester der Fumar- oder Maleinsäure, Maleinimide;

6) Aromatische Vinyl- und Divinylverbindungen, wie Styrol, Methylstyrol, Divinylbenzol;

7) Vinylchlorid, Vinylidenchlorid;

8) Di- und Polyacrylate sowie Di- und Polymethacrylate von Glykolen mit 2 bis 6 C-Atomen und Polyolen mit 3-4 Hydroxylgruppen und 3 bis 6 C-Atomen, wie Ethylenglykoldiacrylat, Propandiol-1,3-diacrylat, Butandiol-1,4-diacrylat, Hexandiol-1,6-diacrylat, Trimethylolpropantriacrylat, Pentaerythrittri- und -tetraacrylat sowie entsprechende Methacrylate, ferner Di- und Polyacrylate sowie Di- und Polymethacrylate von Polyethern der vorgenannten Glykole und Polyole. Die Polyether sind Umsetzungsprodukte aus vorgenannten Glykolen bzw. Polyolen mit 1,2-Alkylenoxiden mit 2-4 C-Atomen, insbesondere mit Ethylen- und Propylenoxid, wobei auf 1 OH-Gruppe

1-20 Alkylenoxideinheiten entfallen können (vergl. US-PS 3 368 900, 3 380 831, 4 180 474).

9) Vinylalkylether mit 1-4 C-Atomen in der Alkylgruppe, wie Vinylmethylether, Vinylethylether, Vinylpropylether, Vinylbutylether;

10) Trimethylolpropandiallylethermono(meth)acrylat, Vinylpyridin, N-Vinylcarbazol, Triallylphosphat, Triallylisocyanurat und andere.

Unter üblichen Monomeren werden ferner

B. ungesättigte, photopolymerisierbare Polyester (vergl. J.Björksten, Polyesters and their application, Reinhold Publ. Corp., New York 1963) und

C. photopolymerisierbare, mehr als eine (Meth)Acryloylgruppe pro Molekül enthaltende Harze, z.B. Epoxyacrylate (vergl. US-PS 4 014 771, GB-PS 1 456 486, US-PS 4 081 492, US-PS 4 049 745, US-PS 4 179 478) und Urethanacrylate (vergl. US-PS 3 782 961, US-PS 4 162 274, DE-OS 2 737 406 und 2 841 880) verstanden.

Die Monomeren B und/oder C können mit einem oder mehreren Monomeren der Gruppe A in beliebigem Verhältnis abgemischt werden.

Bevorzugt sind Monomere der Gruppe C, gegebenenfalls in Abmischung mit einem oder mehreren Monomeren der Gruppe A, insbesondere mit den Monomeren der Gruppe A8.

Die Epoxiacrylate sind Umsetzungsprodukte von Polyepoxiden, z.B. Bisphenol-A-bisglycidylether oder deren höherkondensierten Produkten und (Meth)Acrylsäure, wobei die Epoxidgruppen ganz oder teilweise mit (Meth) Acrylsäure verestert wurden. Die Polyepoxide können auch vorher modifiziert worden sein, z.B. durch Ammoniak oder aliphatische oder cycloaliphatische Amine zu Stickstoff enthaltenden Polyepoxiden, die anschließend mit (Meth)Acrylsäure umgesetzt werden. Weitere Modifikation durch gesättigte, aliphatische, cycloaliphatische und aromatische Carbonsäuren ist möglich. Die Epoxiacrylate sind bekannte Monomere, die beispielsweise in den vorstehend angegebenen Patentschriften ausführlich abgehandelt werden. Erfindungsgemäße Mischungen aus Epoxiacrylaten, gegebenenfalls in Abmischung mit Poly(meth)acrylaten der Gruppe A8, und Aroylphosphonsäureester können als hochreaktive, härtbare Überzugsmittel für Papier, Karton, Holz, Leder, Kunststoffe, Textilien, Glas, keramische Materialien und Metalle oder als Bindemittel in derartigen Überzugsmitteln und in Druckfarben eingesetzt werden.

Das gleiche gilt für die in der Literatur ausführlich abgehandelten Urethanacrylate, beispielsweise aus Diisocyanat (1 Mol) und Hydroxialkylacrylat (2 Mol) oder aus Prepolymeren der Polyisocyanate mit freien Isocyanatgruppen und Hydroxialkylacrylaten. Darüberhinaus sind erfindungsgemäße Mischungen aus Urethanacrylaten, gegebenenfalls weiteren Monomeren A, insbesondere der Gruppe A8, und Aroylphosphonsäurealkylestern als Photoresiste und zur Herstellung von Photopolymerdruckplatten vorzüglich geeignet.

Mischungen aus mindestens einem üblichen Monomeren mit vorzugsweise einer ethylenisch ungesättigten, photopolymerisierbaren Doppelbindung und Aroylphosphonsäurediestern der Formel I eignen sich zur Photopolymerisation in Masse zur Herstellung thermoplastisch oder duroplastisch verarbeitbarer Homo- und Copolymerisate.

Prinzipiell ist es möglich, die Aroylphosphonsäurediester der Formel I auch in Mischung mit anderen bekannten Photoinitiatoren oder Photosensibilisatoren einzusetzen.

Die erfindungsgemäßen Mischungen können 0.001 bis 0.1 Gew.-%, bezogen auf Gesamtmischung, an Polymerisationsinhibitoren oder Antioxidantien enthalten, um die Monomeren vor vorzeitiger Polymerisation bzw. Gelierung zu bewahren.

Geeignete Hilfsmittel dieser Art sind beispielsweise Phenole und Phenolderivate, vorzugsweise sterisch gehinderte Phenole, die in beiden o-Stellungen zur phenolischen Hydroxigruppe Alkylsubstituenten mit 1-6 C-Atomen enthalten, Amine, vorzugsweise sekundäre Acrylamine und ihre Derivate, Chinone, Kupfer-I-Salze organischer Säuren oder Anlagerungsverbindungen von Kupfer(I)halogeniden an Phosphite.

Da in manchen Fällen die Mischungen der Erfindung hochviskos sind, ist es möglich, eine geeignete Viskosität durch Abmischen mit inerten Lösungsmitteln wie Butylacetat, Ethylacetat, Ethanol, Isopropanol, Butanol, Aceton, Ethylmethylketon, Diethylketon, Cyclohexan, Cyclohexanon, Cyclopentan, Cyclopentanon, n-Heptan, N-Hexan, n-Octan, Isooctan, Toluol, Xylol, Methylenchlorid, Chloroform, 1,1-Dichlorethan, 1,2-Dichlorethan, 1,1,2-Trichlorethan, Tetrachlorkohlenstoff einzustellen. Solche verarbeitungsgerechten Viskositäten werden erhalten, wenn die Mischungen 5 bis 50 Gew.-%, vorzugsweise 20 bis 40 Gew.-% an Lösungsmitteln, bezogen auf Gesamtmischung, enthalten.

Häufig kann es vorteilhaft sein, sei es zur Verbesserung der filmbildenden Eigenschaften der Harzmassen oder aber,um eine besonders kratzfeste Oberfläche der Schichten zu erhalten, weitere Zusätze zu verwenden. So ist ein Abmischen mit anderen Harztypen, beispielsweise mit gesättigten Polyestern durchaus möglich.

Vorzugsweise werden die Harze in Mengen von 1 - 50 Gew.-%, bezogen auf die polymerisierbaren Komponenten,eingesetzt. Grundsätzlich sollten jedoch nur solche Harze mitverwendet und ihre Menge soweit begrenzt werden, daß eine Beeinträchtigung der Reaktivität nicht auftritt. Geeignete,in der Lackindustrie gebräuchliche Lackharze sind in den Lackrohstofftabellen von E.Karsten, 5. Auflage, Curt R. Vincentz Verlag, Hannover, 1972, Seiten 74-106, 195-258, 267-293, 335-347, 357-366 beschrieben.

Vorteilhafte Zusätze, die zu einer weiteren Steigerung der Reaktivität führen können, sind bestimmte tert. Amine,wie z.B. Triethylamin und Triethanolamin. Ähnlich wirksam ist der Zusatz von Mercaptoverbindungen wie Dodecylmercaptan, Thioglykolsäureester, Thiophenol oder Mercaptoethanol. Die genannten Stoffe werden vorzugsweise in Mengen von 0 bis 5 Gew.-%, bezogen auf die polymerisierbaren Komponenten, eingesetzt.

Werden Füllstoffe bei der Verwendung der erfindungsgemäßen Mischungen als UV-Licht-härtende Überzüge mitverwendet, so ist deren Einsatz auf solche beschränkt, die durch ihr Absorptionsverhalten den Polymerisationsvorgang nicht unterdrücken. Beispielsweise können Talkum, Schwerspat, Kreide, Gips, Kieselsäuren, Asbestmehle und Leichtspat als lichtdurchlässige Füllstoffe verwendet werden, in sehr dünnen Schichten kann auch $TiO_2$ mitverwendet werden.

Als Lichtquellen für die Durchführung von Polymerisationen mit den erfindungsgemäßen Mischungen können übliche UV-Strahler, deren Emission im Bereich von 250-500 nm liegt, verwendet werden. Vorteilhaft sind Quecksilberdampf-, Xenon- oder Wolframlampen, insbesondere Quecksilberhochdruckbrenner, Quecksilbermitteldruckbrenner oder Quecksilberniederdruckstrahler ,sowie superaktinische Leuchtstoffröhren.

Beispiel 1 (Herstellung der Photoinitiatoren)

In einem 250 ml Dreihalskolben, versehen mit Rührer, Rückflußkühler, Tropftrichter mit Druckausgleich, Thermometer und Gasableitungsrohr mit Blasenzähler, werden 49.6 g (0,4 Mol) Trimethylphosphit so zu 42.2 g (0.3 Mol) Benzoylchlorid getropft, daß die Innentemperatur 35°C nicht überschreitet. Anschließend wird das Reaktionsgemisch 1 Stunde bei 35°C nachgerührt und anschließend fraktionierend destilliert. 61.3 g Benzoylphosphonsäuredimethylester als schwach gelbgefärbtes Öl vom $Sdp._{0.1 - 0.2}$ 110 - 115°C; $n_D^{20}$ 1.5243 (Lit.: C.A. 40, 4688 (1946) $Sdp._{3.5}$ 144.5 - 146.0°C, $n_D^{20}$ 1.5254).

Analog der vorstehenden Vorschrift wurden die in den Beispielen eingesetzten Aroylphosphonsäurealkylester hergestellt.

Beispiel 2

Es wird ein Urethanacrylat hergestellt durch Umsetzung von 111.0 g Isophorondiisocyanat (0.5 Mol) mit 46,4 g Hydroxiethylacrylat (0.4 Mol), 6.1 g Thiodiglykol (0.05 Mol) und 134.0 g eines oxethylierten Trimethylolpropans mit einer OH-Zahl von 250 (Mol.Gew. 675). Dieses Harz wird 75 Gew.-%ig in Trishydroxiethyltrimethylolpropantrisacrylat (Umsetzungsprodukt aus 3 Mol Acrylsäure und einem Mol eines mit 3 Moläquivalenten Ethylenoxid umgesetzten Trimethylolpropans) gelöst und mit jeweils 2 Gew.-% der in Tabelle 1 aufgeführten Photoinitiatoren versetzt. Die einzelnen Harzproben werden in 50 nm dicker Schicht auf weißen Karton aufgetragen und unter einer 7 cm entfernten UV-Lampe (Typ Hanovia Q 500 W) auf einem

regelbaren Fließband vorbeigeführt. In Tabelle 1 sind die max. Bandgeschwindigkeiten wiedergegeben. Alle Proben verändern auch bei einer Lagerung über 35 Tage bei 60°C ihre Konsistenz nicht und sind auch anschließend einwandfrei härtbar.

Tabelle 1

| Initiator | Bandgeschwindigkeit bis zur vollständigen Aushärtung. (m/min.) | Farbe der Überzüge |
|---|---|---|
| p-Chlorbenzoylphosphonsäuredimethylester<br>Sdp.$_{0.9}$ 137°C, $n_D^{20}$ 1.5414 | 15 | farblos |
| Benzoylphosphonsäurediethylester<br>Sdp.$_{0,5}$ 121°C, $n_D^{20}$ 1.5062 | 5 | farblos |
| p-Anisoylphosphonsäuredimethylester<br>Sdp.$_{0.35}$ 153°C, $n_D^{20}$ 1.5493 | 30 | schwach gelb |
| Benzoylphosphonsäuredimethylester | 20 | farblos |
| ß-Naphthoylphosphonsäuredimethylester<br>Sdp.$_{0.5}$ 171°C, $n_D^{20}$ 1.5962 | 2.5 | farblos |
| o-Chlorbenzoylphosphonsäuredimethylester<br>Sdp.$_{0.4}$ 132°C, $n_D^{20}$ 1.5300 | 5 | farblos |
| p-tert.-Butylbenzoylphosphonsäuredimethylester<br>Sdp.$_{0.35}$ 146-151°C, $n_D^{20}$ 1.5218 | 30 | farblos |

| Initiator | | Bandgeschwindigkeit bis zur vollständigen Aushärtung (m/min.) | Farbe der Überzüge |
|---|---|---|---|
| Benzildimethylketal | (Vergleich) | 30 | gelb |
| α-Cyanäthylbenzoin-ethylether | (Vergleich) | 20 | schwach gelb |

Beispiel 3

340.0 g Bisphenol-A-bis-glycidylether (Epoxidäquivalent 190) werden mit 115.0 g Acrylsäure, 5.0 g Natriumstearat und 0.05 g Hydrochinonmonomethylether vermischt und 15 h unter Rühren auf 60°C erwärmt. Nach dieser Zeit hat das Reaktionsgemisch eine Säurezahl von 7. Es werden 235.0 g Trimethylolpropantrisacrylat und jeweils 14.0 g (2 Gew.-%) der in Tab. 2 aufgeführten Photoinitiatoren (Siedepunkte und Brechungsindices siehe Tabelle 1) hinzugegeben. Nach dem Abkühlen werden 100 nm dicke Schichten mit einem Handcoater auf Papier aufgetragen, die anschließend auf einem regelbaren Fließband in einem Abstand von 7 cm unter einer UV-Lampe (Typ Hanovia Q 500 W) gehärtet werden. Wie in Beispiel 2 angeführt, wird jeweils die max. Bandgeschwindigkeit registriert, die zu einer vollständigen Aushärtung der Schichten führt. Auch in diesem Harzsystem beträgt die Dunkellagerfähigkeit bei 60°C mind. 35 Tage.

Tabelle 2

| Initiator | Bandgeschwindigkeit bis zur vollständigen Aushärtung (m/min.) | Farbe der Überzüge |
|---|---|---|
| p-Chlorbenzoylphosphonsäuredimethylester | 10 | farblos |
| Benzoylphosphonsäuredimethylester | 10 | farblos |
| p-Anisoylphosphonsäuredimethylester | 20 | gelb |
| Benzoylphosphonsäurediethylester | 10 | farblos |
| ß-Naphthoylphosphonsäuredimethylester | 2 | farblos |
| o-Chlorbenzoylphosphonsäuredimethylester | 40 | farblos |
| p-tert.-Butylbenzoylphosphonsäuredimethylester | 30 | farblos |
| Benzildimethylketal (Vergleich) | 30 | gelb |
| α-Cyanethylbenzoinethylester (Vergleich) | 20 | schwach gelb |

Patentansprüche:

1) Mischungen enthaltend, bezogen auf Summe aus Monomer und Photoinitiator,

a) 85 bis 99.9 Gew.-% mindestens eines üblichen Monomeren mit mindestens einer ethylenisch ungesättigten, photopolymerisierbaren Doppelbindung und

b) 0.1 bis 15 Gew.-% mindestens eines Photoinitiators,

dadurch gekennzeichnet, daß der Photoinitiator ein Aroylphosphonsäurediester der Formel I

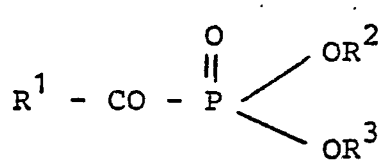

(I)

ist,
worin
$R^1$ einen Phenyl-, Naphthyl-, Pyridyl- oder Furylrest oder einen der vorstehenden Reste, die durch Halogen (F, Cl, Br) $C_1$-$C_4$ Alkyl-, $C_1$-$C_4$ Alkoxi-, Alkoxicarbonyl- mit 1 bis 4 C-Atomen in der Alkoxigruppe, Phenyl- oder Nitro-($-NO_2$)gruppen substituiert sind, bedeutet und

$R^2$ und $R^3$ gleich oder verschieden einen $C_1$-$C_4$ Alkyl-, $C_2$-$C_4$ Alkenyl- oder Benzylrest oder einen der vorstehenden, durch Halogen

(F, Cl, Br), Trihalogenmethyl- oder $C_1$-$C_4$ Alkoxigruppen substituierten Rest oder $R^2$ und $R^3$ zusammen eine Alkylengruppe $(-CH_2-)_x$ darstellen, wobei x eine Zahl von 2 bis 4 ist.

2) Mischungen gemäß Anspruch 1, dadurch gekennzeichnet, daß in Formel I $R^1$ Phenyl oder durch F oder Cl, $C_1$-$C_4$ Alkyl, $C_1$-$C_4$ Alkoxi, Alkoxicarbonyl mit 1-4 C-Atomen in der Alkoxigruppe oder durch $NO_2$ substituiertes Phenyl und $R^2$ und $R^3$ gleich oder verschieden Methyl oder Ethyl bedeuten.